# EUROPÄISCHE PATENTSCHRIFT

(11) **EP 4 295 122 B1**
(45) Veröffentlichungstag und Bekanntmachung des Hinweises auf die Patenterteilung: **25.06.2025**
(21) Anmeldenummer: 22711895.7
(22) Anmeldetag: 21.02.2022
(51) Int. Cl.: G01F 23/24, G01F 23/26

(54) **KONTAKTIERUNGSEINHEIT FÜR EINEN IMPEDANZGRENZSCHALTER**
CONTACT UNIT FOR AN IMPEDANCE LIMIT SWITCH
UNITÉ DE CONTACT POUR UN INTERRUPTEUR DE LIMITE D'IMPÉDANCE

(30) Priorität: 22.02.2021 DE 102021201661
(43) Veröffentlichungstag der Anmeldung: 27.12.2023
(73) Patentinhaber: VEGA Grieshaber KG, 77709 Wolfach (DE)
(72) Erfinder: BECHERER, Frank, 77743 Neuried (DE); BADER, Tobias, 77716 Haslach (DE)
(74) Vertreter: Maiwald GmbH
(86) Internationale Anmeldenummer: PCT/EP2022/054260
(87) Internationale Veröffentlichungsnummer: WO 2022/175525

(56) Entgegenhaltungen:
- EP-A1- 3 599 670
- WO-A1-2016/091497
- WO-A1-98/02937
- DE-A1- 102011 004 807
- US-A1- 2004 004 487

## Beschreibung

Die vorliegende Anmeldung beansprucht die Priorität der deutschen Patentanmeldung Nr. 10 2021 201 661.8, eingereicht am 22. Februar 2021.

### Gebiet der Erfindung

Die Erfindung betrifft im Allgemeinen den Bereich der elektrischen Kontaktierung in einem Messgerät. Insbesondere betrifft die Erfindung eine Kontaktierungseinheit für einen Impedanzgrenzschalter, einen Impedanzgrenzschalter mit einer solchen Kontaktierungseinheit und die Verwendung einer solchen Kontaktierungseinheit.

### Hintergrund

Innerhalb oder außerhalb eines Feldgeräts oder eines Sensors sind zahlreiche elektrische Kontaktierungen notwendig, die zu unterschiedlichen Zwecken dienen. Dabei kann eine elektrische Kontaktierung mittels Stecker und Buchse erfolgen. Des Weiteren können beispielsweise Flexleiter im Bereich der Lasertechnik und/oder der Messtechnik verwendet werden, meistens in Verbindung mit Flachbandkabeln.

DE 10 2011 004 807 A1 betrifft eine Sondeneinheit mit zumindest abschnittsweise koaxialem Aufbau. Insbesondere betrifft die Erfindung eine Sondeneinheit für eine Vorrichtung zur kapazitiven oder konduktiven Bestimmung mindestens einer Prozessgröße eines Mediums in einem Behälter. Bei der Prozessgröße handelt es sich beispielsweise um den Füllstand und/oder die elektrische Leitfähigkeit und/ oder die Permittivität des Mediums.

### Zusammenfassung der Erfindung

Es ist eine Aufgabe der vorliegenden Erfindung, eine Kontaktierungseinheit für einen Impedanzgrenzschalter bereitzustellen, welche eine hohe elektrische Kontaktzuverlässigkeit ermöglicht.

Diese Aufgabe wird durch die Merkmale der unabhängigen Patentansprüche gelöst. Weiterbildungen der Erfindung ergeben sich aus den Unteransprüchen und der folgenden Beschreibung von Ausführungsformen.

Ein erster Aspekt der vorliegenden Offenbarung betrifft eine Kontaktierungseinheit für einen Impedanzgrenzschalter, welche zur Herstellung eines elektrischen Kontakts zwischen zumindest einer Kontaktfläche einer Leiterplatte und zumindest einer Elektrode des Impedanzgrenzschalters eingerichtet ist. Die Kontaktierungseinheit weist eine Leiterplatte mit einer elektrisch leitenden Kontaktfläche, eine radial angeordnete Ringfeder zur Herstellung eines elektrischen Kontakts zwischen der Kontaktfläche der Leiterplatte und der Elektrode des Impedanzgrenzschalters und ein nicht leitfähiges Gehäuseelement auf.

Bei der Leiterplatte kann es sich um einen Elektronik-Kontaktierungsprint, um eine Elektronikbaugruppe oder um jeden Träger von elektronischen Bauteilen handeln. Es sei bemerkt, dass die Kontaktierungseinheit mehrere Leiterplatten aufweisen kann. Die Leiterplatte kann beispielsweise ferner eine Buchseneinheit und/oder eine Stifteinheit aufweisen, sodass die Leiterplatte darüber an einer Elektronikeinheit verbindbar sein kann. Die Leiterplatte kann Elektronikkomponenten aufweisen. Die Leiterplatte kann, abgesehen von der Kontaktfläche, aus Kunststoff gefertigt sein. Bei der Kontaktfläche kann es sich im Allgemeinen um jede Fläche handeln die leitend im Kontakt oder in Berührung mit der Ringfeder sein kann. Mit der Herstellung eines elektrischen Kontakts kann somit ein Stromkreis hergestellt werden.

Bei der Ringfeder kann es sich um eine Donut-artige und/oder eine Volltorus-artige Feder handeln. Jedoch sind auch andere Geometrien möglich. Die Ringfeder kann radial oder aber auch axial angeordnet sein. Es sei bemerkt, dass mehrere Ringfedern ebenso denkbar sind.

Der Impedanzgrenzschalter kann dazu eingerichtet sein oder konfiguriert sein, einen Grenzstand und/oder einen Füllstand eines Behälters und/oder eines Gewässers und/oder einer Lagerstelle zu messen. Der Impedanzgrenzschalter kann jedes beliebige Medium in jedem beliebigen Behältnis messen. Der Impedanzgrenzschalter kann über die nötige Elektronik verfügen um solche Messungen durchführen zu können. Der Impedanzgrenzschalter kann ferner derart ausgeführt sein, dass er an einem Behälter befestigt werden kann.

Sensoren, wie zum Beispiel Impedanzgrenzschalter, können Vibrationen ausgesetzt werden, sodass es sich vorteilhaft erweisen kann, einen vibrationsfesten elektrischen Kontakt in einem solchen Sensor zu verwenden. Mit einem vibrationsfesten elektrischen Kontakt können beispielsweise Abbrüche im Stromkreis vermieden werden. Der Stromkreis kann im vorliegenden Fall mit der Ringfeder geschlossen und/oder garantiert werden. Durch den Kontakt mehrerer Windungen oder Wicklungen und/oder durch die Verwendung einer Ringfeder zur Herstellung des elektrischen Kontakts kann eine größere Kontaktsicherheit zwischen der Kontaktfläche der Leiterplatte und der Elektrode erreicht werden. Die Ringfeder kann eine radiale und axiale Toleranzkompensation anbieten. Somit kann zum Beispiel eine solche Kontaktierungseinheit die Empfindlichkeit gegen Vibrationen eines Impedanzgrenzschalters mindern.

Erfindungsgemäß ist die Kontaktfläche der Leiterplatte an einer von zwei gegenüberliegenden Kerben der Leiterplatte angeordnet. Alternativ kann die Kontaktfläche der Leiterplatte an mehreren Kerben der Leiterplatte angeordnet sein. Mit anderen Worten kann die Kontaktfläche der Leiterplatte derart angeordnet sein, dass der Kontakt zwischen der Kontaktfläche und der Ringfeder optimiert werden kann.

Gemäß einer Ausführungsform sind die Kerben in radialer Richtung der Leiterplatte gegenüberliegend voneinander angeordnet und weisen einen Kerbradius auf, welcher dem Zylinderradius der Ringfeder entspricht. Mit anderen Worten können die Kerben derart ausgeführt sein, dass die auf der Außenkontur der Ringfeder möglichst passend anliegen, wobei der Begriff "möglichst passend" im Kontext der vorliegenden Anmeldung breit zu verstehen ist. Damit kann der Kontakt zwischen der Kontaktfläche der entsprechenden Kerbe und der Ringfeder erhöht werden. Die Kerben können auch andere Kerbradien oder Geometrien aufweisen.

Gemäß einer Ausführungsform ist das Gehäuseelement dazu eingerichtet, die Ringfeder an die Leiterplatte über deren Kerbe zu klemmen. Dabei ist es zum Beispiel denkbar, dass das Gehäuseelement einen hierfür vorgesehenen Leerraum oder eine Vertiefung aufweist. Dabei kann ein solcher Leerraum oder eine solche Vertiefung beispielsweise derart angeordnet sein, dass er oder sie gegenüber der Kontaktfläche der Leiterplatte sein kann. Somit kann zum Beispiel die Ringfeder im Leerraum des Gehäuseelements oder in einer Vertiefung des Gehäuseelements aufgenommen werden, sodass die Ringfeder in optimalem Kontakt mit der Kontaktfläche der Leiterplatte gehalten werden kann.

Gemäß einer Ausführungsform ist die Kontaktierungseinheit zum Aufstecken auf einem Elektronikbecher des Impedanzgrenzschalters eingerichtet. Hierfür kann beispielsweise das Gehäuseelement mechanische Verbindungsvorrichtungen aufweisen und/oder einen Aufsteckmechanismus aufweisen. Der Begriff "Aufstecken" ist im Kontext der vorliegenden Anmeldung breit zu verstehen. Damit kann zum Beispiel Verbinden, Ankoppeln oder Klammern gemeint sein.

Gemäß einer Ausführungsform ist die Elektrode eine Messsonde, eine Schirmelektrode und/oder ein Prozessanschluss. Mit anderen Worten kann der kontaktierte Bereich Bestandteil einer Messelektrode, einer Schirmelektrode und/oder eines Prozessanschlusses sein. Dabei kann es sich auch um ein Schirmelement handeln, welches beispielsweise über die Ringfeder herausragen kann.

Gemäß einer Ausführungsform umschließt, überdeckt und/oder umhüllt die Schirmelektrode eine oder mehrere Ringfedern.

Gemäß einer Ausführungsform ist das Gehäuseelement zweiteilig ausgeführt und weist einen Halter und einen Einsatz auf. Der Halter und der Einsatz sind geometrisch aufeinander abgestimmt, sodass der Einsatz in den Halter einrastbar ist, um die Ringfeder aufzunehmen und zu fixieren. Mit anderen Worten kann das Gehäuseelement baugruppenartig aufgebaut sein. Ein zweiteiliges Gehäuseelement kann beispielsweise bei der Montage oder Demontage der Kontaktierungseinheit vorteilhaft sein. So können zum Beispiel eine oder mehrere Ringfedern an den Halter angebracht werden und erst nachher durch das Anbringen oder das Einrasten des Einsatzes in den Halter fixiert werden.

Gemäß einer Ausführungsform ist das Gehäuseelement rotationssymmetrisch ausgeführt. Ein rotationssymmetrisches Gehäuse kann sich zum Beispiel als vorteilhaft erweisen, wenn die Kontaktierungseinheit über einem Gewinde an den Impedanzgrenzschalter angebracht wird. Möglich ist zudem, dass die Leiterplatte ebenfalls rotationssymmetrisch ausgeführt ist.

Gemäß einer Ausführungsform ist die Kontaktfläche der Leiterplatte mit einem elektrisch leitenden Material beschichtet. Alternativ oder zusätzlich ist die Ringfeder mit einem elektrisch leitenden Material beschichtet. Beim elektrisch leitenden Material kann es sich um Keramik, Silber, Kupfer, Gold und/oder Graphen handeln. Es kann sich dabei auch um eine Legierung handeln.

Gemäß einer Ausführungsform ist das Gehäuseelement aus Kunststoff mittels eines Spritzverfahrens gefertigt.

Gemäß einer Ausführungsform weist die Kontaktierungseinheit zwei oder drei konzentrisch angeordnete Ringfedern auf. Jede der zwei oder der drei Ringfedern können in elektrischem Kontakt mit unterschiedlichen Elektroden, Messsonden und/oder Prozessanschlüssen sein.

Gemäß einer Ausführungsform weist die Leiterplatte für jede Ringfeder jeweils zwei Kerben auf. Die entsprechenden zwei Kerben sind dazu eingerichtet, die elektrische Kontaktierung zwischen der entsprechenden Ringfeder und der Leiterplatte bereitzustellen. Somit kann zum Beispiel jede Ringfeder einen unterschiedlichen Stromkreis bilden. Denkbar ist zum Beispiel, dass die eine Ringfeder zum einen im Kontakt mit einer Kontaktfläche der Leiterplatte und gleichzeitig im Kontakt mit einer Messsonde ist. Die zweite Ringfeder kann beispielsweise zum einen im Kontakt mit einer Kontaktfläche der Leiterplatte und gleichzeitig im Kontakt mit einem Prozessanschluss sein.

Gemäß einer Ausführungsform weisen die zwei oder drei konzentrisch angeordneten Ringfedern unterschiedliche Zylinderradien und/oder unterschiedliche Ringdurchmesser auf. Es sei bemerkt, dass eine beliebige Anzahl an Ringfedern ebenso denkbar ist. Somit können die unterschiedlichen Ringfedern an unterschiedlichen Stellen der Leiterplatte und/oder der Kontaktierungseinheit angeordnet sein. Mit dem Begriff "Stellen" kann eine axiale und/oder radiale Position gemeint sein.

Ein weiterer Aspekt der vorliegenden Offenbarung betrifft einen Impedanzgrenzschalter. Der Impedanzschalter weist eine Kontaktierungseinheit, so wie voranstehend und nachfolgend beschrieben, einen Elektronikbecher und einen Messkopf, welcher dazu eingerichtet ist eine konduktive und/oder kapazitive Messung durchzuführen und Messdaten zu erfassen, auf. Die Kontaktierungseinheit ist dazu eingerichtet, die Messdaten vom Messkopf über die Kontaktierungseinheit an den Elektronikbecher weiterzuleiten.

Ein weiterer Aspekt der vorliegenden Offenbarung betrifft die Verwendung einer Kontaktierungseiheit, so wie voranstehend und nachfolgend beschrieben, zur Weiterleitung von Messdaten von einem Messkopf über die Kontaktierungseinheit an einen Elektronikbecher eines Messgeräts.

Im Folgenden werden mit Verweis auf die Figuren Ausführungsformen der vorliegenden Offenbarung beschrieben. Werden in der folgenden Figurenbeschreibung die gleichen Bezugszeichen verwendet, so bezeichnen diese gleiche oder ähnliche Elemente. Die Darstellungen in den Figuren sind schematisch und nicht maßstäblich.

### Kurze Beschreibung der Figuren

Fig. 1 zeigt eine Kontaktierungseinheit gemäß einer Ausführungsform.
Fig. 2 zeigt eine Kontaktierungseinheit gemäß einer weiteren Ausführungsform.
Fig. 3a und 3b zeigen einen Impedanzgrenzschalter gemäß einer Ausführungsform.
Fig. 4 zeigt eine Kontaktierungseinheit gemäß einer weiteren Ausführungsform.
Fig. 5a bis 5e zeigen eine Kontaktierungseinheit gemäß einer weiteren Ausführungsform.
Fig. 6 zeigt einen Impedanzgrenzschalter gemäß einer weiteren Ausführungsform.

### Detaillierte Beschreibung von Ausführungsformen

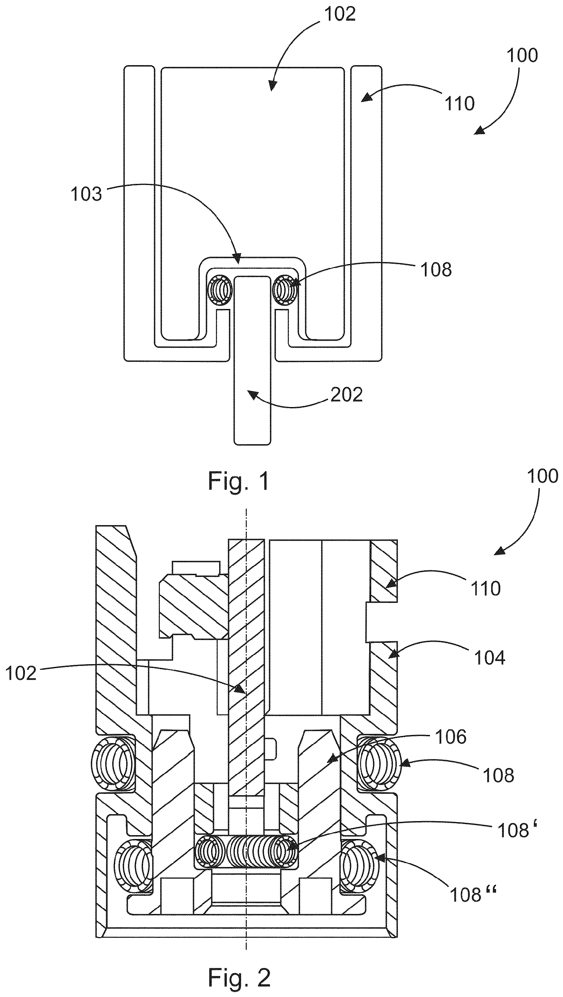

Figur 1 zeigt eine Kontaktierungseinheit 100 gemäß einer Ausführungsform. Insbesondere zeigt Figur 1 eine Schnittdarstellung einer Kontaktierungseinheit. Die Kontaktierungseinheit der Figur 1 weist eine Leiterplatte 102 mit einer elektrisch leitenden Kontaktfläche 103, ein elektrisch nichtleitendes Gehäuseelement 110 und eine Ringfeder 108 auf. Die Ringfeder 108 ist derart angeordnet und ausgeführt, dass sie zur elektrischen Kontaktierung zwischen der Leiterplatte und einer Elektrode 202 eines Impedanzgrenzschalters (in Fig. 1 nicht gezeigt) dient. Hierfür kann die Ringfeder 108 mit einem elektrisch leitenden Material beschichtet sein oder gar aus einem elektrisch leitenden Material gefertigt sein. Beispielsweise ist die Ringfeder 108 vergoldet. Die Kontaktfläche 103 der Leiterplatte 102 kann ebenso mit einem elektrisch leitenden Material beschichtet sein. Eine elektrische Kontaktierung findet somit zwischen der Ringfeder 108 und der Kontaktfläche 103 und zwischen der Ringfeder 108 und der Elektrode 202 statt. Die Ringfeder 108 kann derart in der Kontaktierungseinheit angeordnet sein, dass sie die Elektrode 202 umringt. Das Gehäuseelement 110 kann zum Beispiel anhand eines Spritzverfahrens aus Kunststoff gefertigt sein. Das Gehäuseelement 110 ist zudem derart ausgeführt, dass es die Ringfeder 108 gegen die Kontaktfläche 103 der Leiterplatte 102 hält oder einklemmt. Die Kontaktierungseinheit der Figur 1 ermöglicht einen kompakten Bauraum, mit gleichzeitiger radialer und axialer Toleranzkompensation und elektrischer Abschirmung.

Figur 2 zeigt eine Kontaktierungseinheit 100 gemäß einer weiteren Ausführungsform. Sofern nicht anders beschrieben, weist die Kontaktierungseinheit 100 der Figur 2 dieselben Elemente und/oder Komponenten wie die Kontaktierungseinheit 100 der Figur 1 auf. Die Kontaktierungseinheit 100 der Figur 2 weist drei Ringfedern 108, 108', 108" auf, welche jeweils einen unterschiedlichen Zylinderradius und Ringradius aufweisen. Das Gehäuseelement 110 ist in der Ausführungsform der Figur 2 zweiteilig ausgeführt und weist einen Halter 104 und einen Einsatz 106 auf. Durch ein zweiteiliges Gehäuseelement 110 kann beispielsweise das Anbringen der Ringfedern 108, 108', 108" bei der Montage der Kontaktierungseinheit 100 vereinfacht werden. Jede Ringfeder 108, 108, 108' steht im elektrisch leitenden Kontakt oder in Berührung mit einer Kontaktfläche der Leiterplatte 102 (hier nicht sichtbar). Sobald die jeweilige Ringfeder 108, 108', 108" ebenso in Kontakt mit einer Elektrode 202 oder mit einem Prozessanschluss ist, kann somit ein Stromkreis entstehen. Mit drei Ringfedern können somit drei Stromkreise gebildet werden.

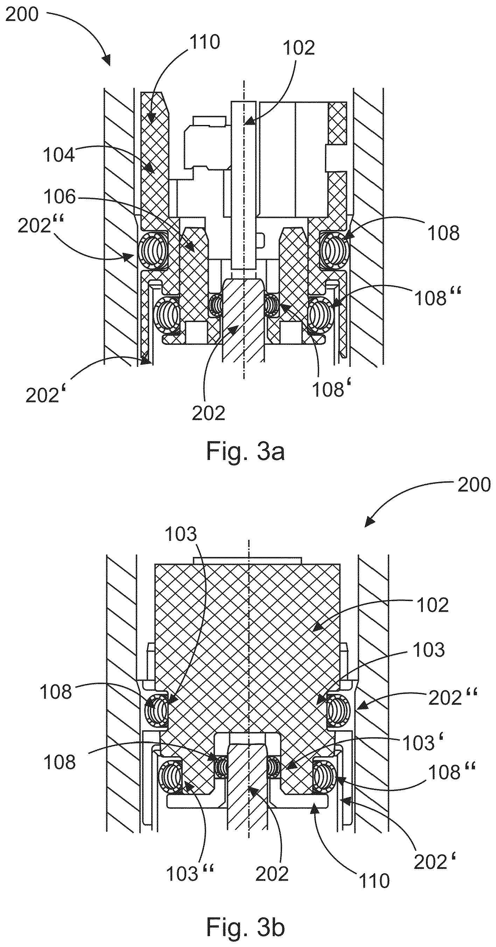

Figuren 3a und 3b zeigen einen Impedanzgrenzschalter 200 gemäß einer Ausführungsform. Insbesondere zeigen Figuren 3a und 3b zwei unterschiedliche Schnittdarstellungen eines Teils eines Impedanzgrenzschalters 200. Es ist anzumerken, dass der Elektronikbecher sowie der Messkopf des Impedanzgrenzschalters 200 in den Figuren 3a und 3b nicht dargestellt sind. Sofern nicht anders beschrieben, weist die Kontaktierungseinheit 100 des Impedanzgrenzschalters der Figuren 3a und 3b dieselben Elemente und/oder Komponenten wie die Kontaktierungseinheit 100 der Figuren 1 und 2 auf. Der Impedanzgrenzschalter 200 weist eine Kontaktierungseinheit 100 auf, so wie voranstehend und nachfolgend beschrieben. Zudem kann der Impedanzgrenzschalter 200 einen Prozessanschluss 202", eine Schirmelektrode 202' und eine Messsonde 202 aufweisen. Die Leiterplatte 102 weist in dieser Ausführungsform, wie in Figur 3b gezeigt, mehrere Kontaktflächen 103, 103', 103" auf. Der Einsatz 106 des Gehäuseelements 110 ist derart ausgeführt, dass er die zwei Ringfedern 108', 108" befestigt, einklemmt oder hält. Die Ringfedern 108, 108', 108" werden derart befestigt, eingeklemmt oder gehalten, dass ein sicherer elektrischer Kontakt zwischen der jeweiligen Kontaktfläche 103, 103', 103" und der Elektrode 202, 202', 202" hergestellt und beibehalten wird.

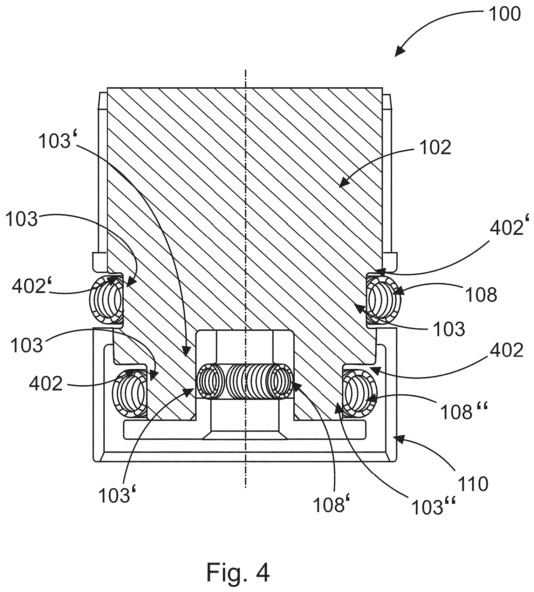

Figur 4 zeigt eine Kontaktierungseinheit gemäß einer Ausführungsform. Insbesondere zeigt Figur 4 eine Schnittdarstellung einer Kontaktierungseinheit. Sofern nicht anders beschrieben, weist die Kontaktierungseinheit 100 der Figur 4 dieselben Elemente und/oder Komponenten wie die Kontaktierungseinheit 100 der Figuren 1 bis 3 auf. Die Leiterplatte 102 der Kontaktierungseinheit 100 der Figur 4 weist zudem mehrere Kerben 402, 402' auf. Solche Kerben 402, 402' können für ein besseres Einklemmen der Ringfedern 108, 108', 108" an die Leiterplatte 102, insbesondere an deren Kontaktfläche 103, 103', 103", dienen. Die Kerben 402, 402' sind in radialer Richtung der Leiterplatte 102 gegenüberliegend voneinander angeordnet. Die Kerben 402, 402' können auch einen Kerbradius aufweisen, welcher dem Zylinderradius der entsprechenden Ringfeder 108, 108', 108' entspricht. Mit anderen Worten können die Kerben eine Außenkontur aufweisen, welche mehr oder weniger der Außengeometrie des Zylinders der Ringfeder 108 entspricht, sodass die Fläche der Kontaktfläche 103, 103', 103", die in Kontakt mit der Ringfeder steht, vergrößert werden kann.

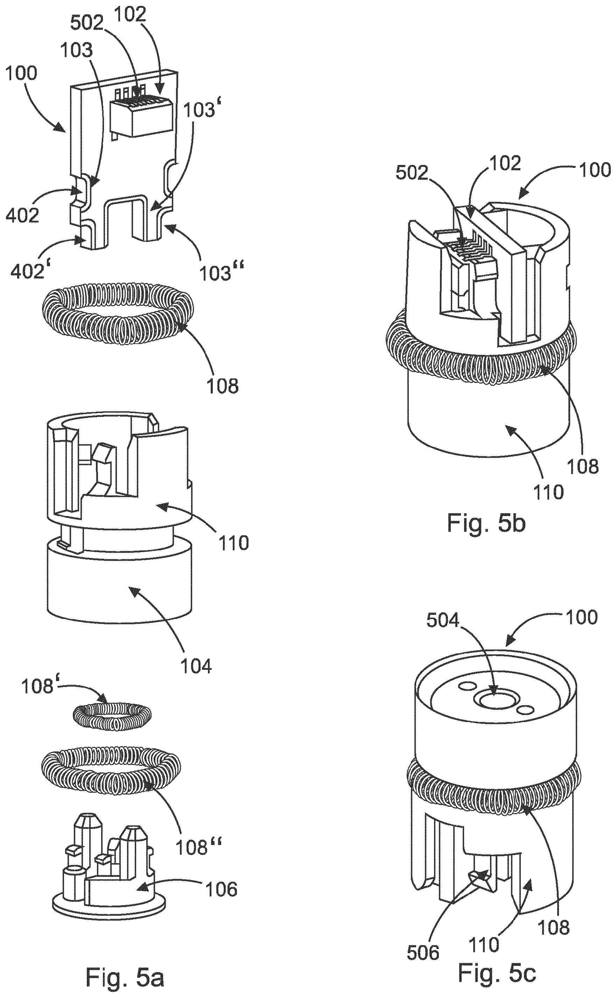

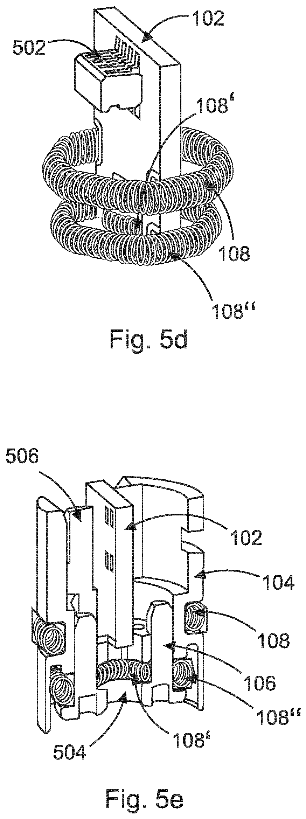

Figuren 5a bis 5e zeigen eine Kontaktierungseinheit 100 gemäß einer Ausführungsform. Insbesondere zeigt Figur 5a eine Explosions-3D-Ansicht der Kontaktierungseinheit 100. Sofern nicht anders beschrieben, weist die Kontaktierungseinheit 100 der Figur 5 dieselben Elemente und/oder Komponenten wie die Kontaktierungseinheit 100 der Figuren 1 bis 4 auf. Die Leiterplatte 102 kann ferner eine Buchseneinheit 502 aufweisen, welche dazu eingestellt sein kann, einen oder mehrere elektrische Kontakte zwischen der Kontaktierungseinheit 100 und einem Elektronikbecher eines Impedanzgrenzschalters 200 herzustellen. Die drei Ringfedern 108, 108',108", welche Donut-artig ausgeführt sind, weisen unterschiedliche Zylinderradien und unterschiedliche Ringradien auf. Das Gehäuse 110 kann einen Leerraum oder eine Vertiefung aufweisen, sodass eine oder mehrere Ringfedern 108, 108', 108' in einem solchen Leerraum oder in einer solchen Vertiefung aufgenommen werden können. Das Gehäuseelement 110 kann ferner eine Verbindungsvorrichtungen 506 aufweisen, welche zum Ausstecken der Kontaktierungseinheit 100 mit einem Elektronikbecher eines Impedanzgrenzschalters 200 konfiguriert sein kann. Ferner kann das Gehäuseelement 110, insbesondere der Einsatz 106, eine Öffnung 504 aufweisen, welche dazu eingerichtet sein kann, eine Messsonde 202 oder eine Elektrode 202 aufzunehmen.

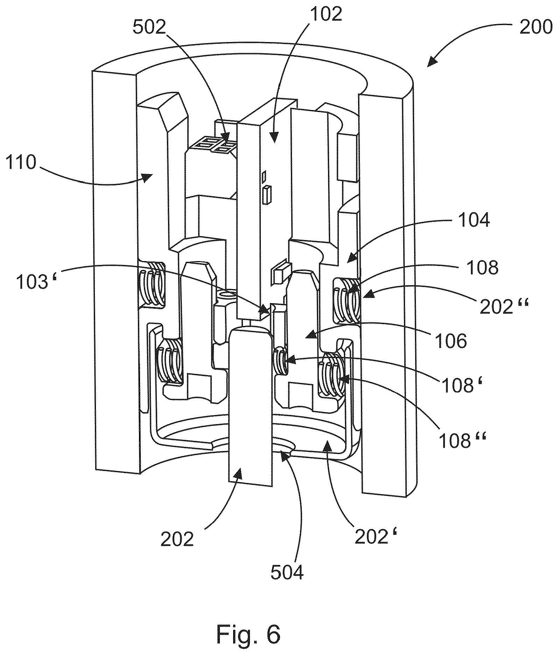

Figur 6 zeigt einen Impedanzgrenzschalter 200 gemäß einer Ausführungsform. Insbesondere zeigt Figur 6 eine 3D-Schnittdarstellung eines Impedanzgrenzschalters 200 mit einer Kontaktierungseinheit 100. Sofern nicht anders beschrieben, weist die Kontaktierungseinheit 100 des Impedanzgrenzschalters der Figur 6 dieselben Elemente und/oder Komponenten wie die Kontaktierungseinheit 100 der Figuren 1 bis 5 auf. Sofern nicht anders beschrieben, weist der Impedanzgrenzschalter 200 der Figur 6 dieselben Elemente und/oder Komponenten wie der Impedanzgrenzschalter 200 der Figur 4 auf. Die Schirmelektrode 202', oder auch als Elektrode bezeichnet, weißt ebenso wie der Einsatz 106 eine Öffnung 504 auf, die dazu eingerichtet ist, die Messsonde 202 in der Kontaktierungseinheit aufzunehmen.

Ergänzend sei darauf hingewiesen, dass "umfassend" und "aufweisend" keine anderen Elemente oder Schritte ausschließt und die unbestimmten Artikel "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Kontaktierungseinheit (100) für einen Impedanzgrenzschalter (200), eingerichtet zur Herstellung eines elektrischen Kontakts zwischen zumindest einer Kontaktfläche (103) einer Leiterplatte (102) und zumindest einer Elektrode (202) des Impedanzgrenzschalters (200), aufweisend:
eine Leiterplatte (102) mit zumindest einer elektrisch leitenden Kontaktfläche (103),
und ein nicht leitfähiges Gehäuseelement (110),
**dadurch gekennzeichnet,**
**dass** eine radial angeordnete Ringfeder (108) zur Herstellung eines elektrischen Kontakts zwischen der Kontaktfläche (103) der Leiterplatte (102) und der Elektrode (202) des Impedanzgrenzschalters (200) vorgesehen ist,
wobei die Leiterplatte zwei einander gegenüberliegenden Kerben aufweist, und
wobei die Kontaktfläche (103) der Leiterplatte (102) an einer der zwei gegenüberliegenden Kerben (402) der Leiterplatte (102) angeordnet ist.

2. Kontaktierungseinheit (100) nach Anspruch 1,
wobei die Kerben (402) in radialer Richtung der Leiterplatte (102) gegenüberliegend voneinander angeordnet sind und einen Kerbradius aufweisen, welcher dem Zylinderradius der Ringfeder (108) entspricht.

3. Kontaktierungseinheit (100) nach einem der Ansprüche 1 oder 2,
wobei das Gehäuseelement (110) dazu eingerichtet ist, die Ringfeder an die Leiterplatte (102) über deren Kerbe zu klemmen.

4. Kontaktierungseinheit (100) nach einem der voranstehenden Ansprüche,
wobei die Kontaktierungseinheit (100) zum Aufstecken auf einem Elektronikbecher des Impedanzgrenzschalters (200) eingerichtet ist.

5. Kontaktierungseinheit (200) nach einem der voranstehenden Ansprüche,
wobei die Elektrode eine Messsonde (202), eine Schirmelektrode (202') und/oder ein Prozessanschluss (202") ist.

6. Kontaktierungseinheit (100) nach Anspruch 5,
wobei die Schirmelektrode (202') die oder mehrere Ringfedern (108) umschließt, überdeckt und/oder umhüllt.

7. Kontaktierungseinheit (100) nach einem der voranstehenden Ansprüche,
wobei das Gehäuseelement (110) zweiteilig ausgeführt ist und einen Halter (104) und einen Einsatz (106) aufweist;
wobei der Halter (104) und der Einsatz (106) geometrisch aufeinander abgestimmt sind, sodass der Einsatz (106) in den Halter (104) einrastbar ist, um die Ringfeder (108) aufzunehmen und zu fixieren.

8. Kontaktierungseinheit (100) nach einem der voranstehenden Ansprüche,
wobei das Gehäuseelement (110) rotationssymmetrisch ausgeführt ist.

9. Kontaktierungseinheit (100) nach einem der voranstehenden Ansprüche,
wobei die Kontaktfläche (103) der Leiterplatte (102) mit einem elektrisch leitenden Material beschichtet ist; und/oder
wobei die Ringfeder (108) mit einem elektrisch leitenden Material beschichtet ist.

10. Kontaktierungseinheit (100) nach einem der voranstehenden Ansprüche,
wobei das Gehäuseelement (110) aus Kunststoff mittels einem Spritzverfahren gefertigt ist.

11. Kontaktierungseinheit (100) nach einem der voranstehenden Ansprüche,
wobei die Kontaktierungseinheit (100) zwei oder drei konzentrisch angeordnete Ringfedern (108, 108', 108") aufweist.

12. Kontaktierungseinheit (100) nach Anspruch 11,
wobei die Leiterplatte für jede Ringfeder (108, 108', 108") jeweils zwei Kerben (402, 402') aufweist, und
wobei die entsprechenden zwei Kerben (402, 402') dazu eingerichtet sind, die elektrische Kontaktierung zwischen der entsprechenden Ringfeder (108, 108', 108") und der Leiterplatte (102) bereitzustellen.

13. Kontaktierungseinheit (100) nach einem der Ansprüche 11 und 12,
wobei die zwei oder drei konzentrisch angeordneten Ringfedern (108, 108', 108") unterschiedliche oder gleiche Zylinderradien und/oder unterschiedliche Ringdurchmesser aufweisen.

14. Impedanzgrenzschalter (200) aufweisend:
eine Kontaktierungseinheit (100) nach einem der Ansprüche 1 bis 13;
einen Elektronikbecher; und
einen Messkopf, welcher dazu eingerichtet ist, eine konduktive und/oder kapazitive Messung durchzuführen und Messdaten zu erfassen;
wobei die Kontaktierungseinheit (100) dazu eingerichtet ist, die Messdaten vom Messkopf über die Kontaktierungseinheit (100) an den Elektronikbecher weiterzuleiten.

15. Verwendung einer Kontaktierungseinheit (100) nach einem der Ansprüche 1 bis 13 zur Weiterleitung von Messdaten von einem Messkopf über die Kontaktierungseinheit (100) an einen Elektronikbecher eines Messgeräts.

## Claims

1. A contacting unit (100) for an impedance limit switch (200), arranged to establish an electrical contact between at least one contact surface (103) of a printed circuit board (102) and at least one electrode (202) of the impedance limit switch (200), comprising
a printed circuit board (102) with at least one electrically conductive contact surface (103), and a non-conductive housing element (110),
**characterised in that** a radially arranged annular spring (108) is provided for producing an electrical contact between the contact surface (103) of the printed circuit board (102) and the electrode (202) of the impedance limit switch (200),
wherein the printed circuit board has two opposing notches, and
wherein the contact surface (103) of the printed circuit board (102) is arranged on one of the two opposing notches (402) of the printed circuit board (102).

2. The contacting unit (100) according to claim 1,
wherein the notches (402) are arranged opposite one another in the radial direction of the printed circuit board (102) and have a notch radius which corresponds to the cylindrical radius of the annular spring (108).

3. The contacting unit (100) according to any one of claims 1 or 2,
wherein the housing element (110) is arranged to clamp the annular spring to the printed circuit board (102) via its notch.

4. The contacting unit (100) according to any one of the preceding claims,
wherein the contacting unit (100) is designed to be plugged onto an electronic cup of the impedance limit switch (200).

5. The contacting unit (100) according to any one of the preceding claims,
wherein the electrode is a measuring probe (202), a shield electrode (202') and/or a process connection (202").

6. The contacting unit (100) according to claim 5,
wherein the shield electrode (202') encloses, covers and/or encases the one or more annular springs (108).

7. The contacting unit (100) according to any one of the preceding claims,
wherein the housing element (110) is designed in two parts and has a holder (104) and an insert (106);
wherein the holder (104) and the insert (106) are geometrically matched to one another, so that the insert (106) can be latched into the holder (104) in order to receive and fix the annular spring (108).

8. The contacting unit (100) according to any one of the preceding claims,
wherein the housing element (110) is rotationally symmetrical.

9. The contacting unit (100) according to any one of the preceding claims,
wherein the contact surface (103) of the printed circuit board (102) is coated with an electrically conductive material; and/or
wherein the annular spring (108) is coated with an electrically conductive material.

10. The contacting unit (100) according to any one of the preceding claims,
wherein the housing element (110) is of plastic by means of an injection moulding process.

11. The contacting unit (100) according to any one of the preceding claims,
wherein the contacting unit (100) has two or three concentrically arranged annular springs (108, 108', 108").

12. The contacting unit (100) according to claim 11,
wherein the printed circuit board has two notches (402, 402') for each annular spring (108, 108', 108"), and
wherein the corresponding two notches (402, 402') are arranged to provide the electrical contact between the corresponding annular spring (108, 108', 108") and the printed circuit board (102).

13. The contacting unit (100) according to one of claims 11 and 12,
wherein the two or three concentrically arranged annular springs (108, 108', 108") have different or identical cylinder radii and/or different ring diameters.

14. An impedance limit switch (200) comprising:
a contacting unit (100) according to any one of claims 1 to 13;
an electronic cup; and
a measuring head which is configured to perform a conductive and/or capacitive measurement and to record measurement data;
wherein the contacting unit (100) is configured to forward the measurement data from the measuring head to the electronic cup via the contacting unit (100).

15. Use of a contacting unit (100) according to any one of claims 1 to 13 for forwarding measurement data from a measuring head via the contacting unit (100) to an electronic cup of a measuring device.

## Revendications

1. Unité de contact (100) pour un interrupteur limiteur à impédance (200), conçue pour établir un contact électrique entre au moins une surface de contact (103) d'une carte de circuit imprimé (102) et au moins une électrode (202) de l'interrupteur limiteur à impédance (200), présentant :
une carte de circuit imprimé (102) comportant au moins une surface de contact électriquement conductrice (103), et
un élément de boîtier non conducteur (110),
**caractérisée en ce**
**qu'**un ressort annulaire (108) disposé radialement est prévu pour établir un contact électrique entre la surface de contact (103) de la carte de circuit imprimé (102) et l'électrode (202) de l'interrupteur limiteur à impédance (200),
dans laquelle la carte de circuit imprimé présente deux encoches opposées l'une à l'autre, et
dans laquelle la surface de contact (103) de la carte de circuit imprimé (102) est disposée au niveau de l'une des deux encoches opposées (402) de la carte de circuit imprimé (102).

2. Unité de contact (100) selon la revendication 1,
dans laquelle les encoches (402) sont disposées de manière opposée l'une à l'autre dans la direction radiale de la carte de circuit imprimé (102) et présentent un rayon d'encoche qui correspond au rayon cylindrique du ressort annulaire (108).

3. Unité de contact (100) selon l'une des revendications 1 ou 2,
dans laquelle l'élément de boîtier (110) est conçu pour serrer le ressort annulaire contre la carte de circuit imprimé (102) par l'intermédiaire de son encoche.

4. Unité de contact (100) selon l'une des revendications précédentes,
dans laquelle l'unité de contact (100) est conçue pour être enfichée sur un boîtier électronique de l'interrupteur limiteur à impédance (200).

5. Unité de contact (200) selon l'une des revendications précédentes,
dans laquelle l'électrode est une sonde de mesure (202), une électrode de blindage (202') et/ou un raccord de processus (202'').

6. Unité de contact (100) selon la revendication 5,
dans laquelle l'électrode de blindage (202') entoure, recouvre et/ou enveloppe le ou les ressorts annulaires (108).

7. Unité de contact (100) selon l'une des revendications précédentes,
dans laquelle l'élément de boîtier (110) est réalisé en deux parties et présente un support (104) et un insert (106) ;
dans laquelle le support (104) et l'insert (106) sont géométriquement adaptés l'un à l'autre de telle sorte que l'insert (106) puisse s'encliqueter dans le support (104) afin de recevoir et de fixer le ressort annulaire (108).

8. Unité de contact (100) selon l'une des revendications précédentes,
dans laquelle l'élément de boîtier (110) est réalisé de manière symétrique en rotation.

9. Unité de contact (100) selon l'une des revendications précédentes,
dans laquelle la surface de contact (103) de la carte de circuit imprimé (102) est recouverte d'un matériau électriquement conducteur ; et/ou
dans laquelle le ressort annulaire (108) est recouvert d'un matériau électriquement conducteur.

10. Unité de contact (100) selon l'une des revendications précédentes,
dans laquelle l'élément de boîtier (110) est fabriqué en matière plastique au moyen d'un procédé d'injection.

11. Unité de contact (100) selon l'une des revendications précédentes,
dans laquelle l'unité de contact (100) présente deux ou trois ressorts annulaires (108, 108', 108'') disposés de manière concentrique.

12. Unité de contact (100) selon la revendication 11,
dans laquelle la carte de circuit imprimé présente deux encoches (402, 402') pour chaque ressort annulaire (108, 108', 108"), et
dans laquelle les deux encoches correspondantes (402, 402') sont conçues pour assurer le contact électrique entre le ressort annulaire correspondant (108, 108', 108'') et la carte de circuit imprimé (102).

13. Unité de contact (100) selon l'une des revendications 11 et 12,
dans laquelle les deux ou trois ressorts annulaires (108, 108', 108'') disposés de manière concentrique présentent des rayons cylindriques différents ou identiques et/ou des diamètres annulaires différents.

14. Interrupteur limiteur à impédance (200) présentant :
une unité de contact (100) selon l'une des revendications 1 à 13 ;
un boîtier électronique ; et
une tête de mesure qui est conçue pour effectuer une mesure conductive et/ou capacitive et pour enregistrer des données de mesure ;
dans lequel l'unité de contact (100) est conçue pour transmettre les données de mesure de la tête de mesure au boîtier électronique par l'intermédiaire de l'unité de contact (100).

15. Utilisation d'une unité de contact (100) selon l'une des revendications 1 à 13 pour transmettre des données de mesure d'une tête de mesure à un boîtier électronique d'un appareil de mesure par l'intermédiaire de l'unité de contact (100).
